Europäisches Patentamt

European Patent Office

Office européen des brevets

(11) Publication number: **0 345 972 B1**

## EUROPEAN PATENT SPECIFICATION

(45) Date of publication of patent specification: **20.07.94**  (51) Int. Cl.5: **H01L 31/02**, H01L 27/14

(21) Application number: **89305313.2**

(22) Date of filing: **25.05.89**

(54) **Quantum-well radiation detector.**

(30) Priority: **06.06.88 US 202860**

(43) Date of publication of application:
**13.12.89 Bulletin 89/50**

(45) Publication of the grant of the patent:
**20.07.94 Bulletin 94/29**

(84) Designated Contracting States:
**DE ES FR GB IT NL**

(56) References cited:
**EP-A- 0 224 189**
**US-A- 4 688 068**
**US-A- 4 711 857**

**JOURNAL OF VACUUM SCIENCE AND TECHNOLOGY B, vol. 1, no. 2, April/June 1983, pages 376-378, New York, US; J.S. SMITH et al.: "A new infrared detector using electron emission from multiple quantum wells"**

**APPLIED PHYSICS LETTERS, vol. 50, no. 16, 20th April 1987, pages 1092-1094, American Institute of Physiscs, New York, US; B.F. LEVINE et al.: "New 10 um infrared detector using intersubband absorption in resonant tunneling GaA1As superlattices"**

(73) Proprietor: **AT&T Corp.**
**32 Avenue of the Americas**
**New York, NY 10013-2412(US)**

(72) Inventor: **Bethea, Clyde George**
**943 Hillside Avenue**
**Plainfield New Jersey 07062(US)**
Inventor: **Levine, Barry Franklin**
**22 Bear Brook Lane**
**Livingston New Jersey 07930(US)**
Inventor: **Malik, Roger John**
**23 Ridgedale Avenue**
**Summit New Jersey 07901(US)**

(74) Representative: **Watts, Christopher Malcolm Kelway, Dr. et al**
**AT&T (UK) LTD.**
**AT&T Intellectual Property Division**
**5 Mornington Road**
**Woodford Green Essex IG8 OTU (GB)**

Rank Xerox (UK) Business Services
(3.10/3.09/3.3.3)

EP 0 345 972 B1

APPLIED PHYSICS LETTERS, vol. 48, no. 15, 14th April 1986, pages 963-965, American Institute of Physics, New York, US; H. TEMKIN et al.: "GexSi1-x strained-layer superlattice waveguide photodetectors operating near 1.3 um"

JOURNAL OF APPLIED PHYSICS, vol. 64, no. 3, 1st August 1988, pages 1591-1593, American Institute of Physics, New York, US; B.F. LEVINE et al.: "Bound-to-extended state absorption GaAs superlattice transport infrared detectors"

ELECTRONICS LETTERS, vol. 24, no. 12, 9th June 1988, pages 747-749, Stevenage, Herts, GB; B.F. Levine et al.: "GaAs/A1GaAs quantum-well, long-wavelength infra-red (LWIR) detector with a detectivity comparable to HgCdTe"

## Description

## Technical Field

The invention is concerned with detector devices as based on excitation of carriers in quantum wells by electromagnetic radiation.

## Background of the Invention

While, largely in the context of terrestrial optical communications at currently favored wavelengths in the vicinity of 1 micrometer, devices for the detection and modulation of visible and near-visible electromagnetic radiation have evolved rapidly, the field of infrared devices has remained relatively less well-developed. Practical long-wave infrared detection devices have been based on opto-electronic activity in materials such as mercury-cadmium telluride or doped silicon, quantum-well detectors using compound semiconductor materials having received mostly theoretical attention. Representative reports concerning the latter are cited as follows:

D. D. Coon et al., "New mode of IR Detection Using Quantum Wells", *Applied Physics Letters*, Vol. 45 (1984), pp. 649-651, disclosing infrared radiation detection as based on charge-depletion in localized impurity levels in semiconductors to which an electric field is applied, charge-depletion taking the form of photoemission from a single $Al_xGa_{1-x}As/GaAs/Al_yGa_{1-y}As$ symmetric quantum well;

J. S. Smith et al., "A New Infrared Detector Using Electron Emission from Multiple Quantum Wells", *Journal of Vacuum Science and Technology*, Vol. B1 (1983), pp. 376-378, disclosing the use of a plurality of GaAs/GaAlAs quantum wells from which electrons are ejected upon excitation by free-carrier absorption - see also U. S. patent 4,620,214, issued October 28, 1986 to S. Margalit et al.; and

L. Esaki et al., "New Photoconductor", *IBM Technical Disclosure Bulletin*, Vol. 20 (1977), pp. 2456-2457, disclosing a superlattice structure in which electrons in the lowest sub-band of quantum wells are essentially immobile, while electrons in a second sub-band have significant mobility.

Typically also, proposals have been made as predicated on photonic excitation of electrons from the valence band to the conduction band, the following being cited further as representative in this respect:

U. S. patent 4,525,731, issued June 25, 1985 to T. I. Chappell et al.; U. S. patent 4,439,782, issued March 27, 1984 to N. Holonyak; U. S. patent 4,607,272, issued August 19, 1986 to G. C. Osbourn; U. S. patent 4,450,463, issued May 22, 1984 to R. Chin; and F. Capasso et al., "New Avalanche Multiplication Phenomenon in Quantum-well Superlattices: Evidence of Impact Ionization Across the Band-edge Discontinuity", *Applied Physics Letters*, Vol. 48 (1986), pp. 1294-1296.

A detector based on the generation of photoelectrons by resonant intersubband absorption and tunneling has been disclosed by B. F. Levine et al., "Quantum-well Avalanche Multiplication Initiated by 10-$\mu$m Intersubband Absorption and Photoexcited Tunneling", *Applied Physics Letters*, Vol. 51 (1987), pp. 934-936. The invention as described below is motivated by the desire to provide for increased efficiency in the collection of photocarriers while, simultaneously, dark-current is kept low.

A device as recited in the preamble of claim 1 is known from Journal of Vacuum Science and Technology B, vol 1, no. 2, April-June 1983, pages 376-378. The response to the device was very slow, being of the order of 1s.

## Summary of the Invention

The invention is predicated on photonic excitation of carriers in quantum wells having a single bound energy state. In the case of carrier electrons, excitation is from a conduction-band bound energy state into the conduction band continuum; in the case of carrier holes, excitation is from a valence-band bound energy state into the valence band continuum. Collection of carriers in the presence of a bias voltage results in an electrical effect such as, e.g., a change in voltage, current, or resistance. In the interest of providing for a single bound energy state, quantum wells have relatively narrow width and, in the interest of limiting dark-current, barriers are relatively wide. Barrier width in preferred devices is significantly greater than quantum-well width; preferably, barriers are at least three times as wide as quantum wells.

Preferred radiation detectors include a plurality of quantum wells as realized by means of a semiconductor superlattice, i.e., a layered structure in which interleaved layers serve as quantum-well and barrier layers. For example, a superlattice can be made as a heterostructure in which quantum-well and barrier layers are made of different materials; also, superlattice structure can be produced in a homogeneous material by periodically varying doping levels. Peak absorption wavelength depends on the choice of materials, and devices of the invention can be designed for infrared absorption at preferred wavelengths from 3 to 15 $\mu$m, longer as well as shorter wavelengths not being precluded.

Preferred devices of the invention have high-speed capability and are suitable for use in heterodyne receivers. Such devices can be used in optical communications and especially in outer space, e.g., between satellites. Also, infrared radiation detection in accordance with a preferred embodiment of the invention can be used for terrain mapping and infrared viewing.

**Brief Description of the Drawing**

FIG. 1 is a schematic side view of a radiation detector in accordance with a first preferred embodiment of the invention;

FIG. 2 is a schematic energy band diagram corresponding to the radiation detector of FIG. 1 as electrically biased, and as implemented using a semiconductor heterostructure;

FIG. 3 is a schematic energy band diagram as corresponding to the radiation detector of FIG. 1 as electrically biased, and as implemented using a semiconductor homostructure in which quantum wells are formed by doped regions;

FIG. 4 is a diagram which graphically shows responsivity as a function of photon energy incident on a device as depicted in FIG. 1;

FIG. 5 is a schematic side view of an array of radiation detectors in accordance with a second preferred embodiment of the invention;

FIG. 6 is a schematic side view of an array of radiation detectors including reflective radiation coupling means in accordance with a third preferred embodiment of the invention;

FIG. 7 is a schematic side view of a two-wavelength detector in accordance with a fourth preferred embodiment of the invention; and

FIG. 8 is a schematic perspective view of a monolithically integrated device in accordance with a fifth preferred embodiment of the invention.

**Detailed Description**

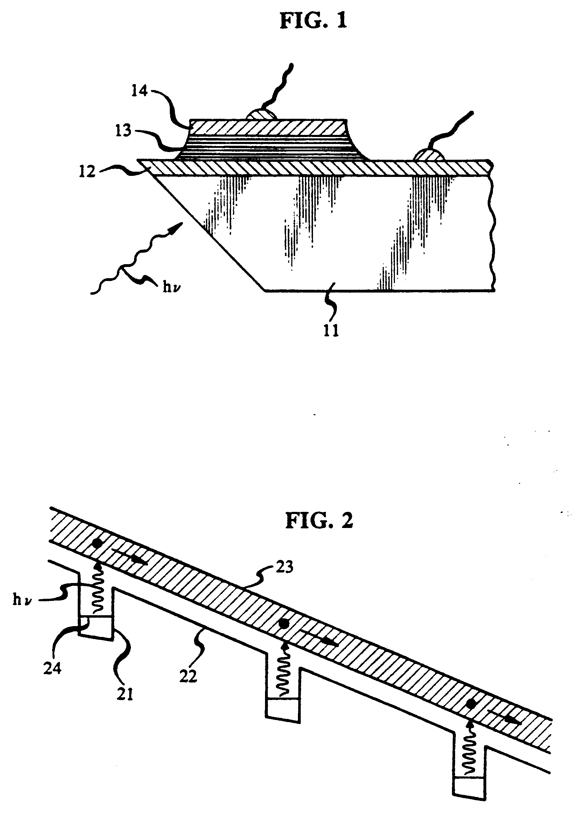

FIG. 1 shows substrate 11 having an angled face adapted for incident radiation $h\nu$. Substrate 11 supports a first contact layer 12, interleaved first and second semiconductor layers forming superlattice 13, and second contact layer 14. When a bias voltage is applied to contact layers 12 and 14, electrical current between such contacts is directly related to the intensity of radiation $h\nu$.

FIG. 2 shows quantum wells 21 between barriers 22 as corresponding to first and second semiconductor layers forming superlattice 13 of FIG. 1. There is a single bound energy state 24 for carriers (electrons, holes) in quantum wells 21, and barrier height is chosen such that incident radiation $h\nu$ of interest excites bound carriers into the continuum energy band 23. In the interest of limiting dark-current, barriers are significantly wider than wells.

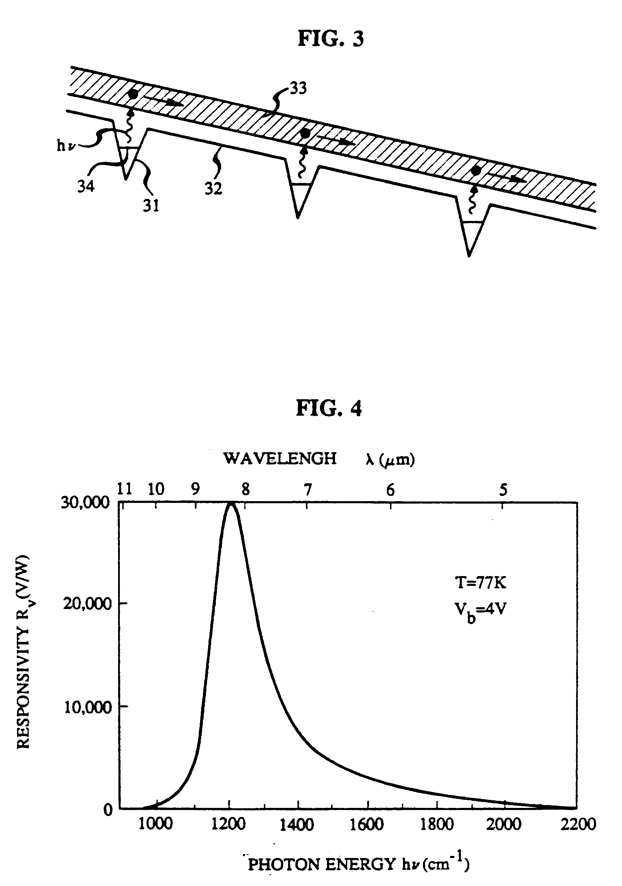

FIG. 3 shows V-shaped quantum wells 31 between barriers 32 as produced by locally heavy dopant concentrations ("spikes") in an otherwise essentially homogeneous semiconductor material. There is a single bound energy state 34 for carriers in quantum wells 31, and barrier height is chosen such that incident radiation $h\nu$ of interest excites bound carriers into the continuum energy band 33. Again, barriers are relatively wide, the width of quantum wells and of barriers conveniently being defined as measured at the level of the bound energy state. Other well profiles such as, e.g., square and trapezoidal shapes are not precluded.

FIG. 4 shows, along the horizontal axis, photon energy $h\nu$ in units of $cm^{-1}$ (or wavelength $\lambda$ in units of $\mu$m) and, along the vertical axis, responsivity $R_v$ in units of V/W). The graph is based on measurements made at a temperature of 77 K and with a bias voltage of 4 V across a 50-period superlattice of interleaved layers of gallium arsenide and aluminum gallium arsenide as further described in an Example below.

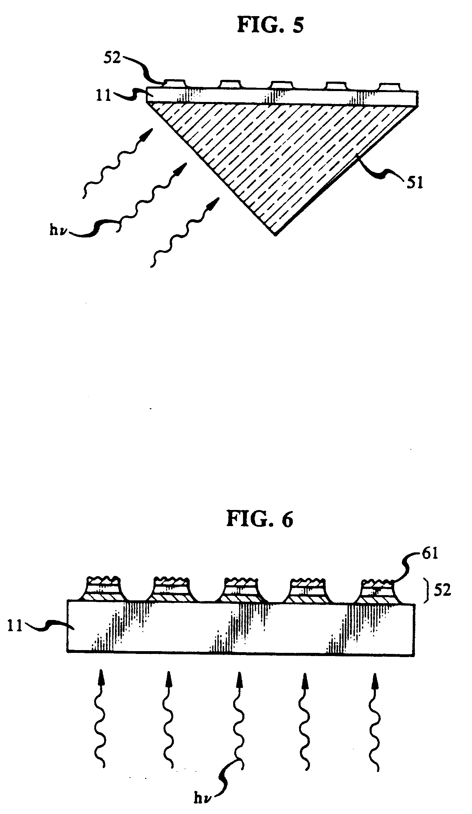

FIG. 5 shows prism 51 attached to (transparent) substrate 11 as adapted for coupling of incident radiation $h\nu$ to detectors 52, each such detector being as depicted in FIG. 1. A preferred radiation coupler serves to direct radiation such that the electric field vector of electromagnetic radiation incident on the superlattice has a component perpendicular to the superlattice. Such coupling function may alternatively be performed by a grating.

FIG. 6 shows detectors 52 on (transparent) substrate 11, incident radiation $h\nu$ being coupled to detectors 52 by means of reflector gratings 61. A detector array as depicted (and as understood in two dimensions) can serve, e.g., as a focal-plane medium in a camera. Instead of gratings, diffusely scattering (roughened) surfaces can be used for coupling.

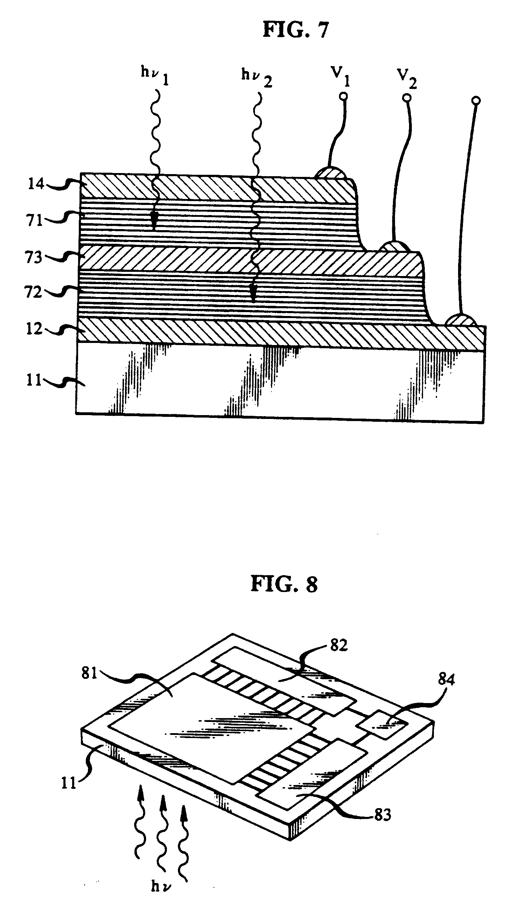

FIG. 7 shows two superlattices 71 and 72 with respective contacts 14 and 73 as supported by substrate 11 with contact 12. Superlattices 71 and 72 are made from different materials as chosen to result in absorption at different wavelengths of interest. Incident radiation components $h\nu_1$ and $h\nu_2$ of interest are shown as being absorbed by respective superlattices 71 and 72 and as producing voltages $V_1$ and $V_2$. While, for the sake of simplicity, radiation is shown incident perpendicular to the superlattice in FIG. 7, optical coupling preferably takes one of the forms as shown in FIG. 1, 5, and 6. A stack arrangement as depicted in FIG. 7 can serve as a spectrometer, alternatively, by omission of contact layer 73, a broadened spectral response can be obtained between contacts 12 and 14. To achieve broadened or otherwise tailored spectral response, grouping together of like quantum wells is not actually required so long as different quantum wells are present in appropriate numbers between contacts 12 and 14. Conversely, for applications requiring high wavelength selectivity, high uniformity of quantum wells is preferred.

By combining stack arrangements according to FIG. 7 into arrays according to FIG. 6, a color camera can be realized. A color camera can be realized also without stacked sensors, in which case detectors having peak sensitivity at different wavelengths are arranged into a focal-plane array, e.g., in periodically alternating fashion.

Preferably, a detector array is monolithically integrated with associated electronics on a common substrate as illustrated by FIG. 8 which shows detector array 81 on substrate 11, array 81 comprising a two-dimensional arrangement of detectors, e.g., in accordance with FIG. 6. The detectors are electrically connected to row-processing electronics 82 and column-processing electronics 83 which, together with image-processing unit 84, are also situated on substrate 11.

A superlattice detector structure may be realized by interleaved first and second layers of suitable Group IV, Group III-V, or Group II-VI materials. In one preferred embodiment Group IV materials are used, quantum wells are p-doped, and device operation involves excitation of valence-band carriers. Another preferred embodiment, involving excitation of conduction-band electrons, is based on the use of Group III-V or Group II-VI materials with n-doped quantum wells. Other doping arrangements are not precluded.

Readily suitable for detection at wavelengths in the "atmospheric window" from 8 to 14 $\mu$m are heterostructure devices having gallium arsenide quantum-well layers and aluminum-gallium arsenide barrier layers. For the detection of 10-$\mu$m radiation, preferred quantum-well width does not exceed 6.5 nm, and preferred barrier width is at least 20 nm. Other typical Group III-V material systems include combinations of aluminum-indium arsenide and indium-gallium arsenide, and of indium phosphide, indium-gallium arsenide, and indium-gallium arsenide-phosphide.

Further, in the interest of maintaining acceptably low dark-current, doping of n-type devices is less than $5 \times 10^{18}$ cm$^{-3}$; similarly, doping of p-type devices is less than $5 \times 10^{19}$ cm$^{-3}$. Dark current further depends on the shape of barriers which may be square, stepped, or graded (e.g., linearly or parabolic), and barrier shape also has an influence on the ease with which excited carriers are transported and collected.

Device manufacture typically involves superlattice fabrication on a substrate under highly controlled conditions as realized, e.g., in molecular-beam epitaxy (MBE) or in metal-organic chemical vapor deposition (MOCVD). Such fabrication technologies are as reviewed, e.g., by A. Y. Cho, "Recent Developments in III-V Compound Semiconductor Materials and Devices", in: J. D. Chadi et al., ed., *Proceedings of the 17th International Conference on the Physics of* Semiconductors, Springer-Verlag, 1985, pp. 1515-1524; and by R. D. Dupuis, "Metal-organic Chemical Vapor Deposition of III-V Semiconductors", *Science*, Vol. 226 (1984), pp. 623-629.

Among advantages of detectors of the invention (e.g., as compared with mercury-cadmium telluride detectors) are the following:

(i) ready availability of suitable, large-size, high-quality, inexpensive substrates;

(ii) availability of well-developed Group III-V and Group IV growth, processing, and passivation technologies, especially as including molecular-beam epitaxial (MBE) deposition with high uniformity, reproducibility, and compositional control over substrates approximately 7.6 cm (3 inches) in diameter or larger.

(iii) potential of monolithic integration with silicon and gallium-arsenide devices such as, e.g., field-effect transistors (FET), charge-coupled devices (CCD), and high-speed signal processing electronics;

(iv) ease of tailoring of the absorption characteristics by means of choice of composition, e.g., to vary the peak absorption wavelength over the atmospheric window; and

(v) superior thermal stability.

The following Example illustrates device structure and performance as realized with a superlattice of interleaved gallium arsenide / aluminum-gallium arsenide layers. All numerical values are nominal or approximate.

Example. On a semi-insulating gallium arsenide substrate, a 1-$\mu$m contact layer of gallium arsenide was deposited (doped n = $2 \times 10^{18}$ cm$^{-3}$), followed by a superlattice detector structure consisting of 50 periods of 4-nanometer gallium arsenide quantum well layers (doped n = $2 \times 10^{18}$ cm$^{-3}$) and 30-nanometer $Al_{0.31}Ga_{0.69}As$ undoped barrier layers (resulting in a barrier height of approximately 250 mV). A top contact layer of 0.5 $\mu$m gallium arsenide was deposited, doped n = $2 \times 10^{18}$ cm$^{-3}$, a mesa having a diameter of 200 $\mu$m was produced by standard photolithographic processing, and contact metallizations were provided by evaporation.

For the measurement of the spectral dependence of the responsivity $R_v$, a glowbar infrared source was used; detector temperature was 77 K, bias voltage was 4 V, and load resistance was 100 k$\Omega$. As can be seen from FIG. 4, the response is peaked at h$\nu$ = 1192 cm$^{-1}$ and has a narrow spectral width of $\Delta$h$\nu$ = 155 cm$^{-1}$ (i.e., $\Delta\nu/\nu$ =

13%). Dark current was found to be 4.5 µA.

For a determination of detectivity, the detector noise was measured under the same conditions by means of a spectrum analyser, and the noise voltage per unit bandwidth was found to be 50 nV $Hz^{-1/2}$ at an optical chopping frequency of 4 kHz, corresponding to a noise-equivalent-power of 1.7 pW $Hz^{-1/2}$. Upon normalization by the device area the detectivity is obtained as $D^* = 1.0 \times 10^{10}$ cm $Hz^{1/2}$/W.

The speed of the detector was measured by means of radiation from a pulsed diode laser and a 50-Ω load resistor. The observed response time of 5 ns was circuit-limited, assuring device capability in the multi-gigahertz range.

## Claims

1.  A device comprising a detector for producing an electrical effect in response to incident electromagnetic radiation at a wavelength of interest, said detector comprising

    a substrate-supported semiconductor superlattice (13) between contact layers (12, 14), said superlattice comprising interleaved quantum-well (21) and barrier (22) layers, quantum wells formed by said layers having a bound energy state which is either a valence-band bound energy state (24) or a conduction-band bound energy state,

    said quantum wells being adapted for carrier excitation by said radiation, excitation being either from said valence-band bound energy state into a valence-band continuum energy state or else from said conduction-band bound energy state into a conduction-band continuum energy state,

    the thickness of said barrier layers being significantly greater than the thickness of said quantum-well layers,

    CHARACTERIZED IN THAT

    said quantum wells have one and only one bound energy state; and

    said wells in n-type devices have a doping of less than $5 \times 10^{18}\,cm^{-3}$ and in p-type devices have a doping of less than $5 \times 10^{19}\,cm^{-3}$.

2.  A device as claimed in claim 1, the thickness of said barrier layers being greater than or equal to three times the thickness of said quantum-well layers.

3.  A device as claimed in claim 1 or claim 2, said wavelength being greater than or equal to 3 µm.

4.  A device as claimed in claim 3, said wavelength being in the range from 3 to 15 µm.

5.  A device as claimed in any of the preceding claims, said superlattice comprising interleaved layers of different materials.

6.  A device as claimed in claim 5, said superlattice comprising Group IV semiconductor materials, and said quantum-well layers being p-doped.

7.  A device as claimed in claim 6, said detector being monolithically integrated with silicon semiconductor devices.

8.  A device as claimed in claim 5, said superlattice comprising Group III-V semiconductor materials, and said quantum-well layers being n-doped.

9.  A device as claimed in claim 8, said detector being monolithically integrated with gallium arsenide semiconductor devices.

10. A device as claimed in any of the preceding claims, said device comprising a plurality of said detectors forming a stack (12, 72, 73, 71, 14), said detectors being responsive to different respective wavelengths of interest.

## Patentansprüche

1.  Einrichtung mit einem Detektor zum Erzeugen eines elektrischen Effektes infolge elektromagnetischer Strahlung bei einer Wellenlänge von Interesse, wobei der Detektor ein substratgestütztes Kalbleiter-Übergitter 13 zwischen Kontaktschichten (12, 14) umfaßt, das Übergitter ineinander verschachtelte Quantentröge (21) und Barrierenschichten (22) umfaßt, die Quantentröge durch Schichten mit einem gebundenen Energiezustand gebildet werden, der entweder ein Valenzband-Bindungsenergiezustand (24) oder ein Leitungsband-Bindungsenergiezustand ist,

    wobei ferner die Quantentröge infolge der Strahlung Ladungsträgeranregung aufweisen können, die Anregung entweder als Übergang vom Valenzband-Bindungsenergiezustand in einen Valenzband-Kontinuum-Energiezustand oder von dem Leitungsband-Bindungsenergiezustand und in einen Leitungsband-Kontinuum-Energiezustand zustande kommt und wobei die Dicke der Barrierenschichten deutlich größer als die Dicke der Quantentrogschichten ist, dadurch gekennzeichnet, daß die Quantentröge nur einen Bindungsenergiezustand haben und die Quantentröge in n-Typ-Einrichtungen eine Dotierung von weniger als $5 \times 10^{18}$ cm$^{-3}$ und in p-Typ-Einrichtungen eine Dotierung von weniger als $5 \times 10^{19}$ cm$^{-3}$ aufweisen.

2. Einrichtung nach Anspruch 1, bei welcher die Dicke der Barrierenschicht größer oder gleich 3 mal der Dicke der Quantentrogschichten ist.

3. Einrichtung nach Anspruch 1 oder 2, wobei die Wellenlänge größer als oder gleich 3 $\mu$m ist.

4. Einrichtung nach Anspruch 3, in welcher die Wellenlänge im Bereich von 3 bis 15 $\mu$m liegt.

5. Einrichtung nach einem der vorstehenden Ansprüche, in welcher das Übergitter ineinander verschachtelte Schichten verschiedener Materialien enthält.

6. Einrichtung nach Anspruch 5, in welcher das Übergitter Gruppe IV-Halbleitermaterialien umfaßt und die Quantentrogschichten p-dotiert sind.

7. Einrichtung nach Anspruch 6, in welcher der Detektor mit Silizium-Halbleitereinrichtungen monolitisch integriert ist.

8. Einrichtung nach Anspruch 5, in welcher das Übergitter Gruppe III-V-Halbleitermaterialien umfaßt und die Quantentrogschichten n-dotiert sind.

9. Einrichtung nach Anspruch 8, in welcher der Detektor mit Gallium-Arsenid-Halbleitereinrichtungen monolitisch integriert ist.

10. Einrichtung nach einem der vorstehenden Ansprüche, wobei die Einrichtung eine Vielzahl der Detektoren, die einen Stapel (12, 72, 73, 71, 14) bilden, umfaßt und die Detektoren auf verschiedene jeweilige Wellenlängen von Interesse ansprechen.

**Revendications**

1. Dispositif comprenant un détecteur pour produire un effet électrique en réponse à un radiation électromagnétique incidente à une longueur d'onde d'intérêt, ledit détecteur comprenant

un super réseau cristallin semiconducteur sur substrat (13) entre des couches de contact (12, 14), ledit super réseau cristallin comprenant un puits quantique imbriqué (21) et des couches d'arrêt (22), les puits quantiques formés par lesdites couches ayant un état énergétique lié qui est soit un état énergétique lié dans la bande de valence (24) soit un état énergétique lié dans la bande de conduction,

lesdits puits quantiques étant adaptés pour l'excitation de porteuse par ladite radiation, l'excitation étant soit depuis ledit état énergétique lié dans la bande de valence en un état énergétique continu dans la bande de valence soit depuis ledit état énergétique lié dans la bande de conduction en un état énergétique continu dans la bande de conduction,

l'épaisseur desdits couches d'arrêt étant considérablement supérieure à l'épaisseur desdites couches de puits quantiques,

CARACTERISE EN CE QUE

lesdits puits quantiques ont un et un seul état énergétique lié; et

lesdits puits dans les dispositifs de type n ont un dopage de moins de $5 \times 10^{18}$ cm$^{-3}$ et dans les dispositifs de type p ont un dopage de moins de $5 \times 10^{19}$ cm$^{-3}$.

2. Dispositif selon la revendication 1, l'épaisseur desdits couches d'arrêt étant supérieure ou égale à trois fois l'épaisseur desdites couches de puits quantiques.

3. Dispositif selon la revendication 1 ou la revendication 2, ladite longueur d'onde étant supérieure ou égale à 3 $\mu$m.

4. Dispositif selon la revendication 3, ladite longueur d'onde étant dans la gamme de 3 à 15 $\mu$m.

5. Dispositif selon l'une quelconque des revendications précédentes, ledit super réseau cristallin comprenant des couches imbriquées de matériaux différents.

6. Dispositif selon la revendication 5, ledit super réseau cristallin comprenant des matériaux semiconducteurs de Groupe IV, et lesdites couches de puits quantiques étant dopées aux impuretés p.

7. Dispositif selon la revendication 6, ledit détecteur étant intégré monolithiquement avec des dispositifs semiconducteurs au silicium.

8. Dispositif selon la revendication 5, ledit super réseau cristallin comprenant des matériaux semiconducteurs des Groupes III à V, et lesdites couches de puits quantiques étant dopées aux impuretés n.

9. Dispositif selon la revendication 8, ledit détecteur étant intégré monolithiquement avec des dispositifs semiconducteurs à l'arséniure de gallium.

10. Dispositif selon l'une quelconque des revendications précédentes, ledit dispositif comprenant une pluralité de dits détecteurs formant une pile (12, 72, 73, 71, 14), lesdits détecteurs étant sensibles à différentes longueurs d'ondes d'intérêt respectives.

**FIG. 1**

**FIG. 2**

## FIG. 3

## FIG. 4

WAVELENGH $\lambda$ ($\mu$m)

T=77K

$V_b$=4V

## FIG. 5

## FIG. 6

## FIG. 7

## FIG. 8